# EUROPEAN PATENT SPECIFICATION

(11) **EP 4 145 513 B1**
(45) Date of publication and mention of the grant of the patent: **01.10.2025**
(21) Application number: 22192279.2
(22) Date of filing: 26.08.2022
(51) Int. Cl.: H10D 86/40, H10D 86/60, H10K 59/131

(54) **DISPLAY PANEL AND DISPLAY DEVICE INCLUDING THE SAME**
ANZEIGETAFEL UND ANZEIGEVORRICHTUNG DAMIT
PANNEAU D'AFFICHAGE ET DISPOSITIF D'AFFICHAGE LE COMPRENANT

(30) Priority: 27.08.2021 KR 20210113865
(43) Date of publication of application: 08.03.2023
(73) Proprietor: Samsung Display Co., Ltd., Yongin-si, Gyeonggi-do 17113 (KR)
(72) Inventor: Kim, Byoungyong, 138-1001 Gwanak-gu, Seoul (KR); Lee, Sangduk, 67-2 Cheoin-gu, Yongin-si, Gyeonggi-do (KR)
(74) Representative: Dr. Weitzel & Partner

(56) References cited:
- CN-A- 110 491 904
- KR-A- 20180 041 301
- KR-A- 20200 091 060
- US-B2- 10 468 435

## Description

### BACKGROUND

### 1. Field

Embodiments of the invention relate to a display panel and a display device including the same. More particularly, embodiments of the invention relate to a high resolution display panel and a display device including the same.

### 2. Description of the Related Art

Flat panel display devices are replacing cathode ray tube display devices due to advantages of the flat panel display devices such as lightweight and thin characteristics. The flat panel display devices include liquid crystal display devices and organic light-emitting diode display devices, for example.

The display device may include a display panel including a plurality of pixels and a plurality of pads, and a driving circuit chip connected to the display panel. The pixels may receive a driving signal from the driving circuit chip through the pads and transmission lines (e.g., fan-out lines) respectively connected to the pads. A large number of the pads and a large number of the transmission lines may be desired to implement a high resolution of the display device.

Reference is made to KR 2018 0041301 A, CN 110 491 904 A, US 10 468 435 B2 and KR 2020 0091060 A.

### SUMMARY

Known display devices, in particular the panels thereof not always develop the necessary reliability.

The said problem will be solved by a display panel according to claim 1
Embodiments of the invention will become apparent from the subclaims and from the description.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the invention.
FIG. 1 is a plan view illustrating an embodiment of a display device.
FIG. 2 is a cross-sectional view taken along line I-I' of FIG. 1.
FIG. 3 is an enlarged plan view of an embodiment of a pad region of the display device of FIG. 1.
FIGS. 4 and 5 are cross-sectional views taken along line II-II' of FIG. 3.
FIG. 6 is a cross-sectional view taken along line III-III' of FIG. 3.
FIG. 7 is a cross-sectional view taken along line IV-IV' of FIG. 3.
FIG. 8 is a cross-sectional view taken along line V-V' of FIG. 3.
FIG. 9 is a cross-sectional view taken along line VI-VI' of FIG. 3.
FIG. 10 is an enlarged plan view of another embodiment of a pad region of the display device of FIG. 1.
FIG. 11 is an enlarged plan view of still another embodiment of a pad region of the display device of FIG. 1.
FIG. 12 is an enlarged plan view of still another embodiment of a pad region of the display device of FIG. 1.
FIG. 13 is an enlarged plan view of still another embodiment of a pad region of the display device of FIG. 1.
FIG. 14 is a cross-sectional view taken along line VII-VII' of FIG. 13.
FIG. 15 is a cross-sectional view taken along line VIII-VIII' of FIG. 13.
FIG. 16 is a cross-sectional view taken along line IX-IX' of FIG. 13.
FIG. 17 is a cross-sectional view taken along line X-X' of FIG. 13.
FIG. 18 is a cross-sectional view taken along line XI-XI' of FIG. 13.
] FIG. 19 is a plan view illustrating another embodiment of a display device.
FIG. 20 is a block diagram illustrating an embodiment of an electronic device including a display device.

### DETAILED DESCRIPTION

Illustrative, non-limiting embodiments will be more clearly understood from the following detailed description in conjunction with the accompanying drawings.

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this invention will be thorough and complete, and will fully convey the scope of the invention to those skilled in the art. Like reference numerals refer to like elements throughout.

It will be understood that when an element is referred to as being "on" another element, it can be directly on the other element or intervening elements may be therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, the singular forms "a," "an," and "the" are intended to include the plural forms, including "at least one," unless the content clearly indicates otherwise. "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. In an embodiment, when the device in one of the figures is turned over, elements described as being on the "lower" side of other elements would then be oriented on "upper" sides of the other elements. The exemplary term "lower," can therefore, encompasses both an orientation of "lower" and "upper," depending on the particular orientation of the figure. Similarly, when the device in one of the figures is turned over, elements described as "below" or "beneath" other elements would then be oriented "above" the other elements. The exemplary terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The term "about" can mean within one or more standard deviations, or within ± 30%, 20%, 10%, 5% of the stated value, for example.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the invention, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. In an embodiment, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the claims.

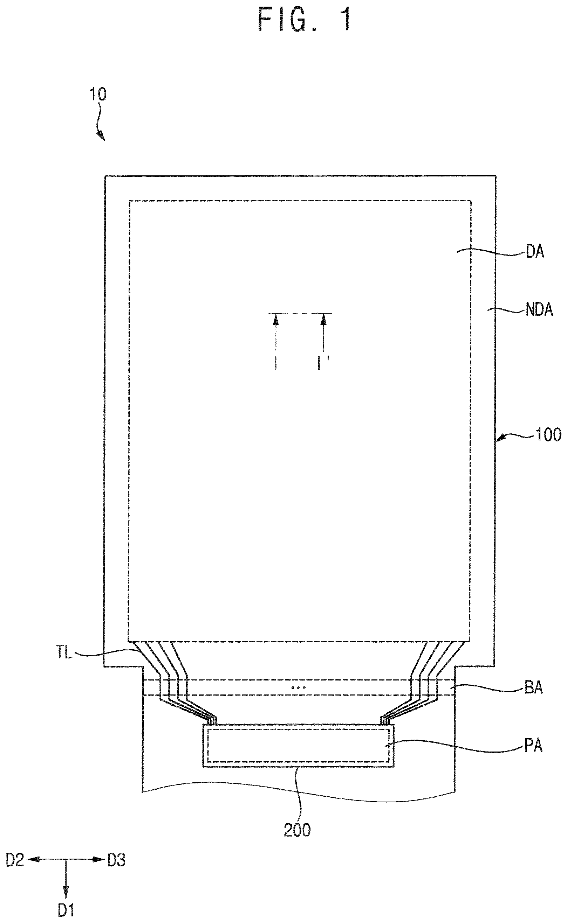

FIG. 1 is a plan view illustrating an embodiment of a display device.

Referring to FIG. 1, a display device 10 in an embodiment may include a display panel 100 and a driving circuit chip 200.

The display panel 100 (or a substrate included in the display panel 100) may include a display region DA and a non-display region NDA. A plurality of pixels for generating an image may be disposed in the display region DA. Light emitted from each of the pixels may be combined to generate the image. In an embodiment, the pixels may be disposed in a matrix form in a first direction D1 and a second direction D2 crossing the first direction D1, for example. The second direction D2 may be perpendicular to the first direction D1. However, the invention is not limited thereto, and the pixels may be disposed in various other forms.

The non-display region NDA may be disposed around the display region DA. In an embodiment, the non-display region NDA may surround the display region DA in a plan view, for example.

The non-display region NDA may include a pad region PA. The pad region PA may be disposed at one side of the display region DA. In an embodiment, the pad region PAmay be spaced apart from the display region DA in the first direction D1, for example. The pad region PA may extend in the second direction D2. A plurality of pads may be disposed in the pad region PA.

In an embodiment, the non-display region NDA may include a bending region BAbetween the display region DA and the pad region PA. The bending region BA may be bent along a bending axis extending in the second direction D2. The bending region BA may be bent such that the pad region PA is disposed under the display region DA.

The display panel 100 may include a plurality of transmission lines TL connecting the display region DA and the pad region PA. The transmission lines TL may be disposed between the display region DA and the pad region PA. Each of the transmission lines TL may include a first end portion adjacent to the pad region PA and a second end portion adjacent to the display region DA. The first end portion of each of the transmission lines TL may be connected to a corresponding one among the plurality of pads. The second end portion of each of the transmission lines TL may be connected to a corresponding one among a plurality of lines (e.g., gate lines, data lines, driving voltage lines, or the like) disposed in the display region DA. The pads may be electrically connected to the pixels through the transmission lines TL, respectively.

The driving circuit chip 200 may be disposed in the pad region PA on the display panel 100. In an embodiment, the driving circuit chip 200 may be directly disposed (e.g., mounted) on the display panel 100 in a chip on plastic ("COP") method, for example. The driving circuit chip 200 may include a plurality of bumps connected to the pads, respectively.

In an embodiment, although not illustrated in the drawings, a flexible printed circuit board ("FPCB") may be attached to an end portion of the display panel 100 in the first direction D1. A printed circuit board ("PCB") may be attached to an end portion of the FPCB.

The driving circuit chip 200, the FPCB, and the PCB may provide a driving signal to the display panel 100. The driving signal may include various signals for driving the display panel 100 such as driving voltage, a gate signal, a data signal, or the like. The driving signal may be transmitted to the pixels disposed in the display region DA through the pads and transmission lines TL.

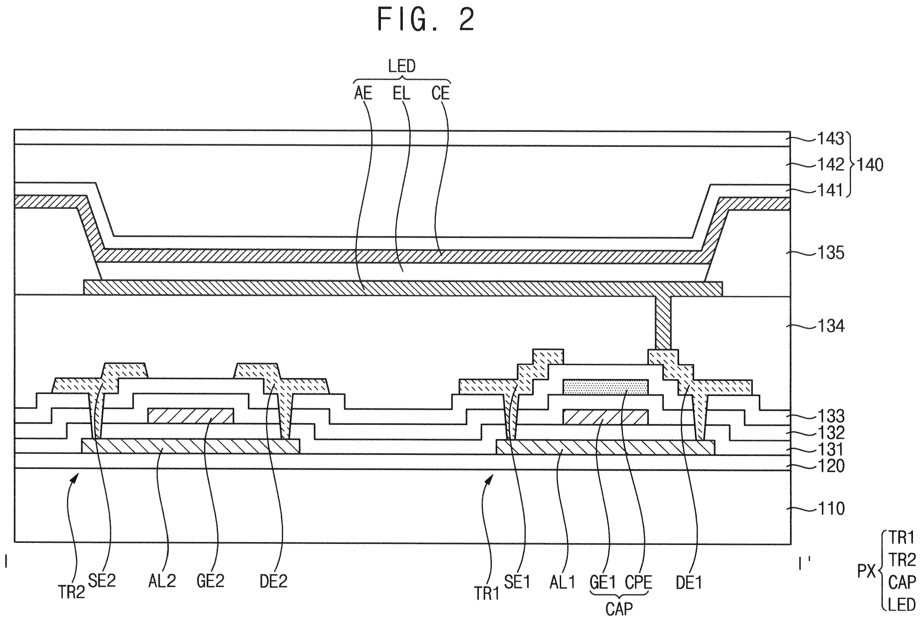

FIG. 2 is a cross-sectional view taken along line I-I' of FIG. 1.

Hereinafter, the display region DA of the display panel 100 will be described in detail with reference to FIGS. 1 and 2.

Referring to FIGS. 1 and 2, in an embodiment, the display panel 100 may include a substrate 110, a buffer layer 120, a pixel PX, and an encapsulation layer 140. The pixel PX may include a first transistor TR1, a second transistor TR2, a capacitor CAP, and a light-emitting element LED.

The substrate 110 may be an insulating substrate including a transparent or opaque material. In an embodiment, the substrate 110 may include glass. In this case, the display panel 100 may be a rigid display panel. In another embodiment, the substrate 110 may include plastic. In this case, the display panel 100 may be a flexible display panel.

The buffer layer 120 may be disposed on the substrate 110. The buffer layer 120 may prevent or reduce instances of impurities diffusing onto the substrate 110. The buffer layer 120 may include an inorganic insulating material such as a silicon compound, a metal oxide, or the like. In an embodiment, the inorganic insulating material may include silicon oxide (SiO), silicon nitride (SiN), silicon oxynitride (SiON), silicon oxycarbide (SiOC), silicon carbonitride (SiCN), aluminum oxide (AlO), aluminum nitride (AlN), tantalum oxide (TaO), hafnium oxide (HfO), zirconium oxide (ZrO), titanium oxide (TiO), or the like, for example. These may be used alone or in any combinations thereof. The buffer layer 120 may have a single-layered structure or a multi-layered structure including a plurality of insulating layers.

The first transistor TR1, the second transistor TR2, and the capacitor CAP may be disposed on the buffer layer 120. The first transistor TR1 may include an active layer AL1, a gate electrode GE1, a source electrode SE1, and a drain electrode DE1. The first transistor TR1 may be a driving transistor connected to the light-emitting element LED. The second transistor TR2 may include an active layer AL2, a gate electrode GE2, a source electrode SE2, and a drain electrode DE2. The second transistor TR2 may be a switching transistor connected to the data line. However, the invention is not limited thereto, and in another embodiment, the source electrode and the drain electrode may be switched with each other according to a type of a transistor.

The active layers AL1 and AL2 may be disposed on the buffer layer 120. Each of the active layers AL1 and AL2 may include an oxide semiconductor, a silicon semiconductor, an organic semiconductor, or the like. In an embodiment, the oxide semiconductor may include at least one oxide of indium (In), gallium (Ga), tin (Sn), zirconium (Zr), vanadium (V), hafnium (Hf), cadmium (Cd), germanium (Ge), chromium (Cr), titanium (Ti), and zinc (Zn), for example. The silicon semiconductor may include an amorphous silicon, a polycrystalline silicon, or the like. Each of the active layers AL1 and AL2 may include a source region, a drain region, and a channel region disposed between the source region and the drain region.

A first insulating layer 131 may be disposed on the active layers AL1 and AL2. The first insulating layer 131 may cover the active layers AL1 and AL2 on the buffer layer 120. The first insulating layer 131 may include an inorganic insulating material.

The gate electrodes GE1 and GE2 may be disposed on the first insulating layer 131. The gate electrode GE1 may overlap the channel region of the active layer AL1, and the gate electrode GE2 may overlap the channel region of the active layer AL2. Each of the gate electrodes GE1 and GE2 may include a conductive material such as a metal, an alloy, a conductive metal nitride, a conductive metal oxide, a transparent conductive material, or the like. In an embodiment, the conductive material may include gold (Au), silver (Ag), aluminum (Al), platinum (Pt), nickel (Ni), titanium (Ti), palladium (Pd), magnesium (Mg), calcium (Ca), lithium (Li), chromium (Cr), tantalum (Ta), tungsten (W), copper (Cu), molybdenum (Mo), scandium (Sc), neodymium (Nd), iridium (Ir), alloys including aluminum, alloys including silver, alloys including copper, alloys including molybdenum, aluminum nitride (AlN), tungsten nitride (WN), titanium nitride (TiN), chromium nitride (CrN), tantalum nitride (TaN), strontium ruthenium oxide (SrRuO), zinc oxide (ZnO), indium tin oxide ("ITO"), tin oxide (SnO), indium oxide (InO), gallium oxide (GaO), indium zinc oxide ("IZO"), or the like, for example. These may be used alone or in any combinations thereof. Each of the gate electrodes GE1 and GE2 may have a single-layered structure or a multi-layered structure including a plurality of conductive layers.

A second insulating layer 132 may be disposed on the gate electrodes GE1 and GE2. The second insulating layer 132 may cover the gate electrodes GE1 and GE2 on the first insulating layer 131. The second insulating layer 132 may include an inorganic insulating material.

The capacitor electrode CPE may be disposed on the second insulating layer 132. The capacitor electrode CPE may overlap the gate electrode GE1. The gate electrode GE1, the second insulating layer 132, and the capacitor electrode CPE may constitute the capacitor CAP.

A third insulating layer 133 may be disposed on the capacitor electrode CPE. The third insulating layer 133 may cover the capacitor electrode CPE on the second insulating layer 132. The third insulating layer 133 may include an inorganic insulating material.

The source electrodes SE1 and SE2 and the drain electrodes DE1 and DE2 may be disposed on the third insulating layer 133. The source electrode SE1 and the drain electrode DE1 may be connected to the source region and the drain region of the active layer AL1, respectively. The source electrode SE2 and the drain electrode DE2 may be connected to the source region and the drain region of the active layer AL2, respectively. Each of the source electrodes SE1 and SE2 and the drain electrodes DE1 and DE2 may include a conductive material.

A fourth insulating layer 134 may be disposed on the source electrodes SE1 and SE2 and the drain electrodes DE1 and DE2. The fourth insulating layer 134 may include an organic insulating material. In an embodiment, the organic insulating material may include a photoresist, a polyacryl-based resin, a polyimide-based resin, a polyamide-based resin, a siloxane-based resin, an acryl-based resin, an epoxy-based resin, or the like, for example. These may be used alone or in any combinations thereof.

An anode electrode AE may be disposed on the fourth insulating layer 134. The anode electrode AE may include a conductive material. The anode electrode AE may be connected to the drain electrode DE1 through a contact hole defined in the fourth insulating layer 134. Accordingly, the anode electrode AE may be electrically connected to the first transistor TR1.

A fifth insulating layer 135 may be disposed on the anode electrode AE. The fifth insulating layer 135 may cover a peripheral portion of the anode electrode AE, and may define a pixel opening exposing a central portion of the anode electrode AE. The fifth insulating layer 135 may include an organic insulating material.

An emission layer EL may be disposed on the anode electrode AE. The emission layer EL may be disposed in the pixel opening of the fifth insulating layer 135. In some embodiments, the emission layer EL may include at least one of an organic light-emitting material or quantum dot.

In an embodiment, the organic light-emitting material may include a low molecular organic compound or a high molecular organic compound. In an embodiment, the low molecular organic compound may include copper phthalocyanine, N,N'-diphenylbenzidine, tris-(8-hydroxyquinoline)aluminum, or the like. In an embodiment, the high molecular organic compound may include poly(3,4-ethylenedioxythiophene), polyaniline, poly-phenylenevinylene, polyfluorene, or the like, for example. These may be used alone or in any combinations thereof.

In an embodiment, the quantum dot may include a core including a Group II-VI compound, a Group III-V compound, a Group IV-VI compound, a Group IV element, and/or a Group IV compound. In an embodiment, the quantum dot may have a core-shell structure including the core and a shell surrounding the core. The shell may serve as a protection layer for preventing the core from being chemically denatured to maintain semiconductor characteristics, and may serve as a charging layer for imparting electrophoretic characteristics to the quantum dot.

A cathode electrode CE may be disposed on the emission layer EL. The cathode electrode CE may also be disposed on the fifth insulating layer 135. The cathode electrode CE may include a conductive material. The anode electrode AE, the emission layer EL, and the cathode electrode CE may constitute the light-emitting element LED.

The encapsulation layer 140 may be disposed on the cathode electrode CE. The encapsulation layer 140 may include at least one inorganic encapsulation layer and at least one organic encapsulation layer. In an embodiment, the encapsulation layer 140 may include a first inorganic encapsulation layer 141 disposed on the cathode electrode CE, an organic encapsulation layer 142 disposed on the first inorganic encapsulation layer 141, and a second inorganic encapsulation layer 143 disposed on the organic encapsulation layer 142.

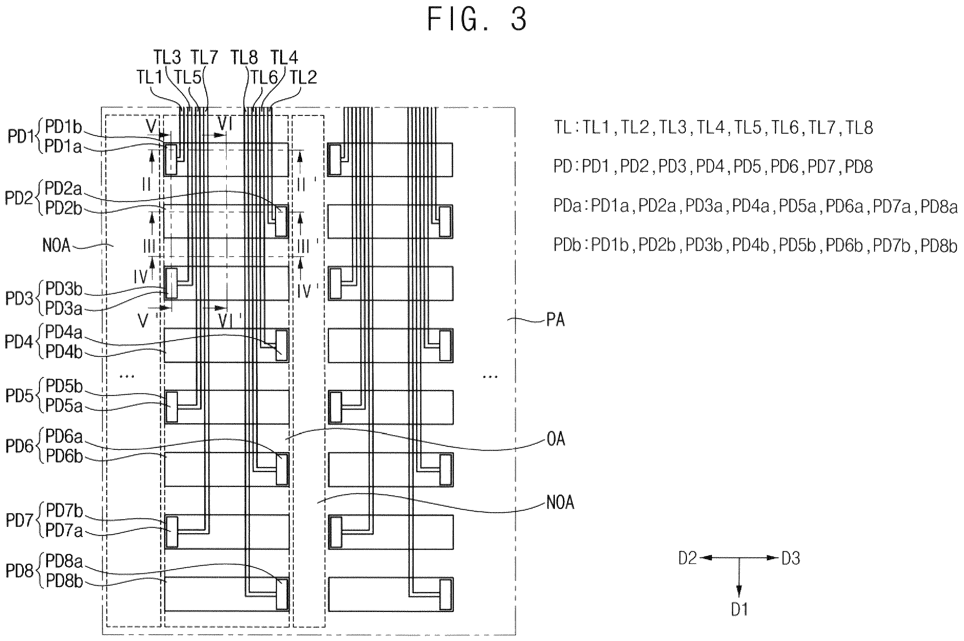

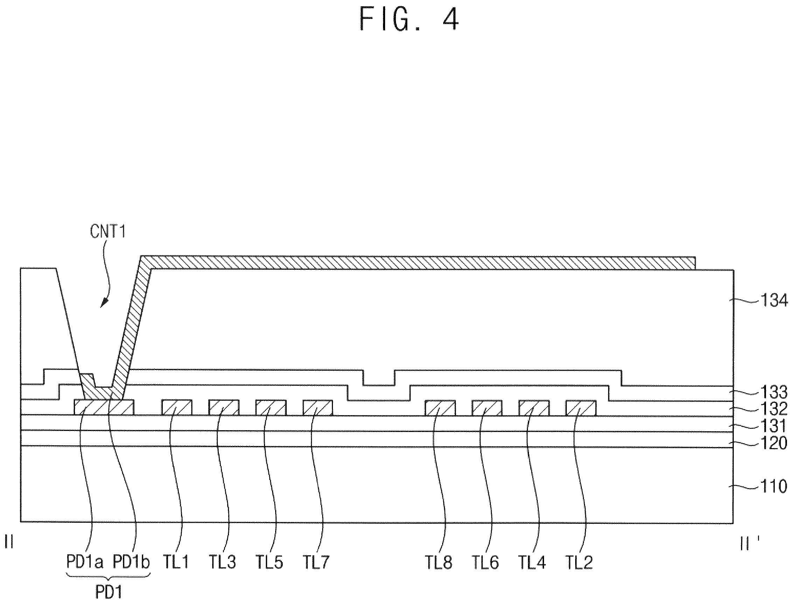

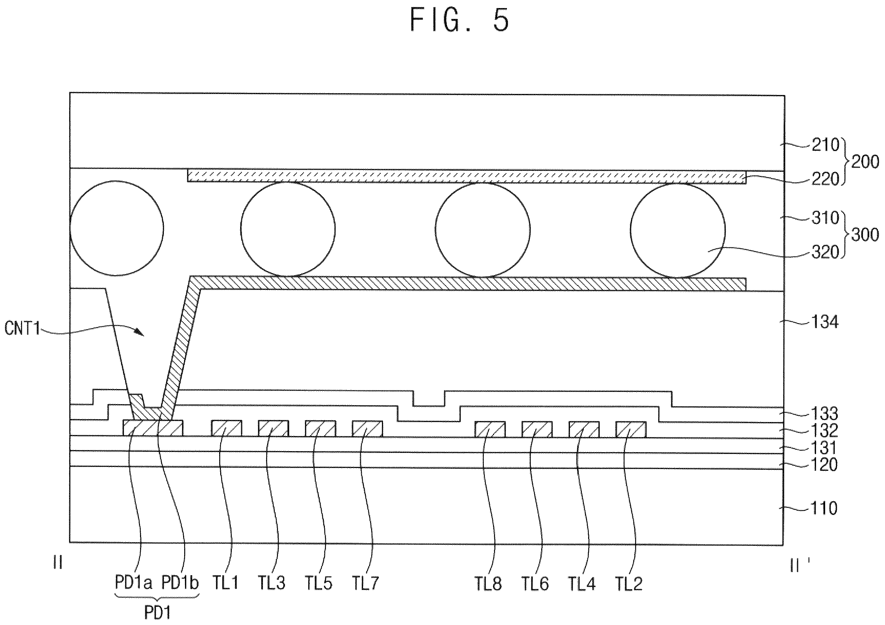

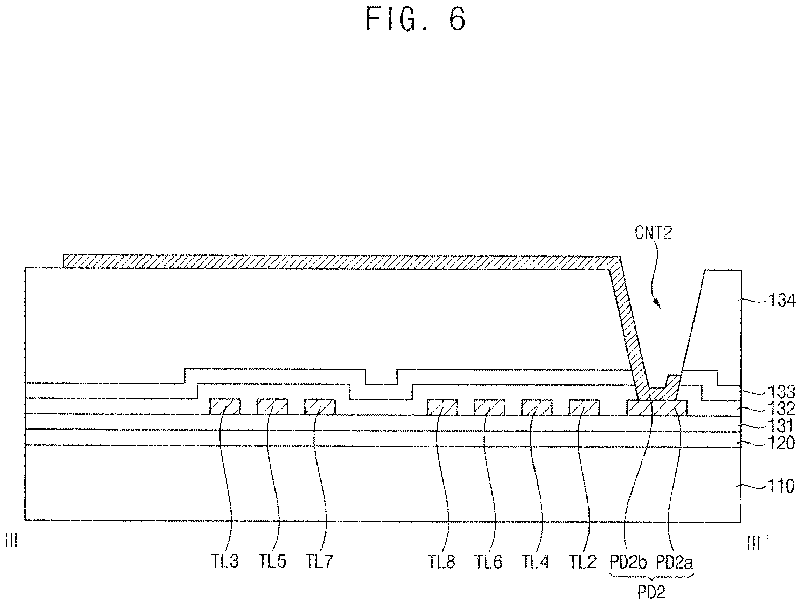

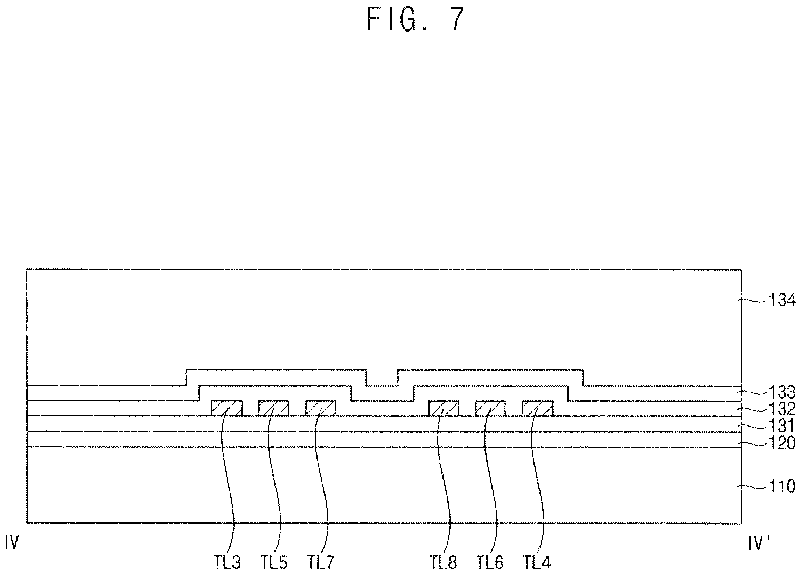

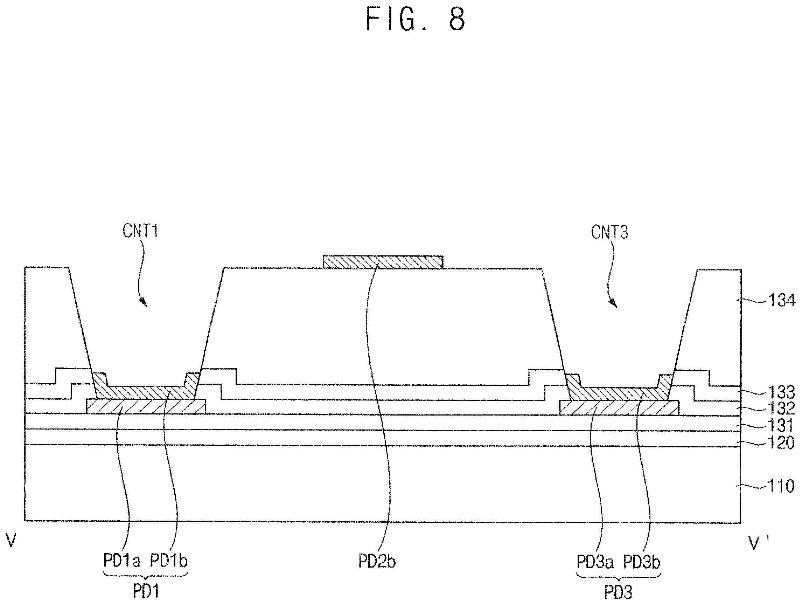

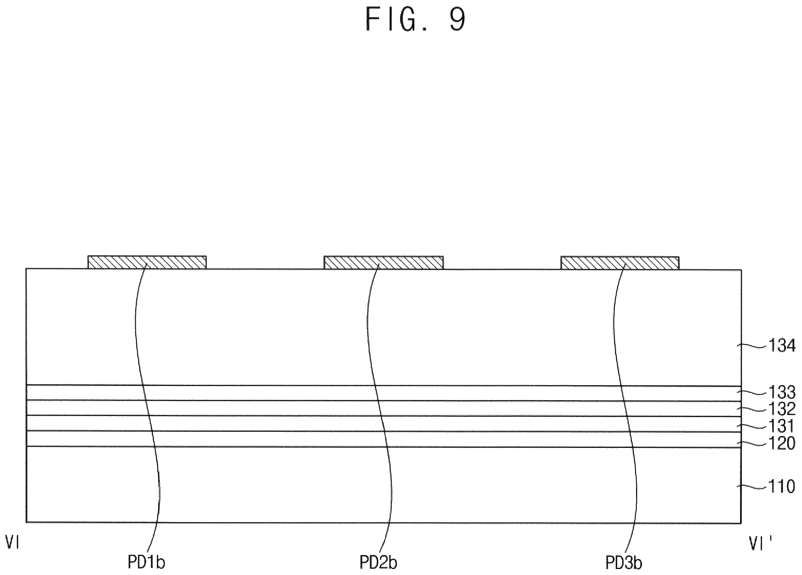

FIG. 3 is an enlarged plan view of an embodiment of a pad region of the display device of FIG. 1. FIGS. 4 and 5 are cross-sectional views taken along line II-II' of FIG. 3. FIG. 6 is a cross-sectional view taken along line III-III' of FIG. 3. FIG. 7 is a cross-sectional view taken along line IV-IV' of FIG. 3. FIG. 8 is a cross-sectional view taken along line V-V' of FIG. 3. FIG. 9 is a cross-sectional view taken along line VI-VI' of FIG. 3. In an embodiment, FIGS. 4, 6, 7, 8 and 9 may be cross-sectional views illustrating the display panel 100, and FIG. 5 may be a cross-sectional view illustrating the display device 10 in which an anisotropic conductive film 300 and the driving circuit chip 200 are disposed on the display panel 100 of FIG. 4, for example.

Hereinafter, the pad region PA of the display panel 100 will be described in detail with reference to FIGS. 1 to 9.

Referring to FIGS. 1 to 9, the display panel 100 may include the plurality of pads PD disposed in the pad region PA. In addition, the first end portions of the plurality of transmission lines TL respectively connected to the plurality of pads PD may be disposed in the pad region PA. In the following description, the transmission line TL may mean the first end portion of the transmission line TL disposed in the pad region PA.

In an embodiment, as illustrated in FIG. 3, the plurality of pads PD may be disposed in a matrix form along the first direction D1 and the second direction D2. That is, the pads PD may be disposed in a plurality of rows and a plurality of columns.

Each of the pads PD includes a lower electrode PDa and an upper electrode PDb disposed on the lower electrode PDa. The lower electrode PDa may be termed as just "an electrode" and the upper electrode PDb may be termed as an opoosite electrode. Each of the upper electrodes PDb extends in the second direction D2. That is, Each of the upper electrodes PDb may extend in a length direction of the pad region PA. An area size of each of the upper electrodes PDb may be greater than an area size of each of the lower electrodes PDa. Each of the lower electrodes PDa may overlap one of opposite end portions of a corresponding upper electrode PDb in a length direction thereof (i.e., an end portion in the second direction D2 or another end portion in the third direction D3). In an embodiment, as illustrated in FIG. 3, the upper electrodes PDb may be disposed in a matrix form along the first direction D1 and the second direction D2 in a plan view, and the lower electrodes PDa may be disposed in a zigzag form in a plan view.

In an embodiment, the lower electrodes PDa may be disposed in the same layer as the transmission lines TL. That is, the lower electrodes PDa may be substantially simultaneously formed or provided with the transmission lines TL. At least one of the upper electrodes PDb may overlap two or more transmission lines TL in a plan view (i.e., in a thickness direction). This will be described later in detail.

An insulating layer may be disposed between the lower electrodes PDa and the upper electrodes PDb. The insulating layer may include at least one organic insulating layer. In an embodiment, the insulating layer may further include at least one inorganic insulating layer. The insulating layer may cover an entirety of the pad region PA. Contact holes respectively overlapping the lower electrodes PDa may be defined in the insulating layer. In an embodiment, the contact holes may be disposed in a zigzag form in a plan view, for example.

The lower electrodes PDa and the transmission lines TL disposed in the pad region PA may be disposed in the same layer as (i.e., may be substantially simultaneously formed or provided with) any one of conductive layers disposed in the display region DA. The upper electrodes PDb may be disposed in the same layer as (i.e., may be substantially simultaneously formed or provided with) another one of the conductive layers disposed in the display region DA. That is, the lower electrodes PDa and the upper electrodes PDb may be substantially simultaneously formed or provided with two conductive layers spaced up and down with at least one organic insulating layer interposed therebetween among the various conductive layers disposed in the display region DA, respectively. In an embodiment, the lower electrodes PDa and the transmission lines TL may be disposed in the same layer as (i.e., may be substantially simultaneously formed or provided with) the gate electrodes GE1 and GE2, for example. The upper electrodes PDb may be disposed in the same layer as (i.e., may be substantially simultaneously formed or provided with) the anode electrode AE. In this case, as illustrated in FIGS. 4 to 9, the insulating layer between the lower electrodes PDa and the upper electrodes PDb may include the second and third insulating layers 132 and 133 as inorganic insulating layers and a fourth insulating layer 134 serving as an organic insulating layer. However, this is merely one of embodiments, and the invention is not limited thereto. In another embodiment, the lower electrodes PDa and the transmission lines TL may be disposed in the same layer as (i.e., may be substantially simultaneously formed or provided with) the capacitor electrode CPE or the drain electrodes DE1 and DE2, for example. In addition, when the third insulating layer 133 is an organic insulating layer, the upper electrodes PDb may be disposed in the same layer as (i.e., may be substantially simultaneously formed or provided with) the drain electrodes DE1 and DE2.

Hereinafter, as illustrated in FIG. 3, the pad region PA of the display panel 100 will be described in more detail with reference to an embodiment in which the pads PD are disposed in eight rows. However, this is merely one of embodiments, and the invention is not limited thereto. In an embodiment, the pads PD may be disposed in two to seven or nine or more rows, for example.

The first to eighth pads PD1, PD2, PD3, PD4, PD5, PD6, PD7, and PD8 may constitute one column. A plurality of columns may be disposed in the second direction D2 and a third direction D3 opposite to the second direction D2 from the column constituted of the first to eighth pads PD1, PD2, PD3, PD4, PD5, PD6, PD7, and PD8. A following description of the column constituted of the first to eighth pads PD1, PD2, PD3, PD4, PD5, PD6, PD7, and PD8 may also be similarly applied to other columns.

The first to eighth pads PD1, PD2, PD3, PD4, PD5, PD6, PD7, and PD8 may be sequentially disposed along the first direction D1. The first to eighth pads PD1, PD2, PD3, PD4, PD5, PD6, PD7, and PD8 may be connected to first to eighth transmission lines TL1, TL2, TL3, TL4, TL5, TL6, TL7, and TL8, respectively.

The first pad PD1 includes a first lower electrode PD1a and a first upper electrode PD1b disposed on the first lower electrode PD1a. The first upper electrode PD1b may overlap the first lower electrode PD1a in a plan view. The first upper electrode PD1b may contact the first lower electrode PD1a through a first contact hole CNT1 defined in the insulating layer. According to the claimed invention, the first lower electrode PD1a extends in the first direction D1. That is, a length of the first lower electrode PD1a in the first direction D1 is greater than a width of the first lower electrode PD1a in the second direction D2.

In an embodiment, the first lower electrode PD1a may be electrically and physically connected to the first transmission line TL1. The first transmission line TL1 may be adjacent to the first lower electrode PD1a in the third direction D3. In an embodiment, the first lower electrode PD1a may be unitary with the first transmission line TL1, for example.

The first upper electrode PD1b extends in the second direction D2. That is, a length of the first upper electrode PD1b in the second direction D2 is greater than a width of the first upper electrode PD1b in the first direction D1.

The first upper electrode PD1b extending in the second direction D2 may have a relatively large area. An area size of the first upper electrode PD1b may be greater than an area size of the first lower electrode PD1a. In an embodiment, as illustrated in FIG. 3, the length of the first upper electrode PD1b in the second direction D2 is greater than the width of the first lower electrode PD1a in the second direction D2.

The first lower electrode PD1a may overlap a portion of the first upper electrode PD1b. In an embodiment, the first lower electrode PD1a may overlap an end portion of the first upper electrode PD1b in the second direction D2.

The second pad PD2 may be adjacent to the first pad PD1 in the first direction D1. The second pad PD2 may include a second lower electrode PD2a and a second upper electrode PD2b disposed on the second lower electrode PD2a. The second pad PD2 may be substantially the same as or similar to the first pad PD1 described above, except that the second lower electrode PD2a overlaps an end portion of the second upper electrode PD2b in the third direction D3.

The second upper electrode PD2b may be adjacent to the first upper electrode PD1b in the first direction D1. The second lower electrode PD2a may overlap an end portion of the second upper electrode PD2b in the third direction D3. The second upper electrode PD2b may contact the second lower electrode PD2a through a second contact hole CNT2 defined in the insulating layer. The second lower electrode PD2a may be electrically and physically connected to the second transmission line TL2. The second transmission line TL2 may be adjacent to the second lower electrode PD2a in the second direction D2. In an embodiment, the second lower electrode PD2a may be unitary with the second transmission line TL2, for example.

Each of the third pad PD3, the fifth pad PD5, and the seventh pad PD7 may be substantially the same as or similar to the first pad PD1. In an embodiment, a third lower electrode PD3a of the third pad PD3 may overlap an end portion of a third upper electrode PD3b in the second direction D2. The third upper electrode PD3b may contact the third lower electrode PD3a through a third contact hole CNT3 defined in the insulating layer, for example. A fifth lower electrode PD5a of the fifth pad PD5 may overlap an end portion of a fifth upper electrode PD5b in the second direction D2. A seventh lower electrode PD7a of the seventh pad PD7 may overlap an end portion of a seventh upper electrode PD7b in the second direction D2. Each of the fourth pad PD4, the sixth pad PD6, and the eighth pad PD8 may be substantially the same as or similar to the second pad PD2. In an embodiment, a fourth lower electrode PD4a of the fourth pad PD4 may overlap an end portion of a fourth upper electrode PD4b in the third direction D3, for example. In an embodiment, a sixth lower electrode PD6a of the sixth pad PD6 may overlap an end portion of a sixth upper electrode PD6b in the third direction D3, for example. In an embodiment, an eighth lower electrode PD8a of the eighth pad PD8 may overlap an end portion of an eighth upper electrode PD8b in the third direction D3, for example. That is, in an embodiment, as illustrated in FIG. 3, the first to eighth upper electrodes PD1b, PD2b, PD3b, PD4b, PD5b, PD6b, PD7b, and PD8b may be disposed in one line along the first direction D1, and the first to eighth lower electrodes PD1a, PD2a, PD3a, PD4a, PD5a, PD6a, PD7a, and PD8a may be disposed in a zigzag form along the first direction D1.

In an embodiment, in the pad region PA, the first to eighth transmission lines TL1, TL2, TL3, TL4, TL5, TL6, TL7, and TL8 may be disposed adjacent to each other. The first to eighth transmission lines TL1, TL2, TL3, TL4, TL5, TL6, TL7, and TL8 may be spaced apart from each other in the second direction D2 and the third direction D3. In an embodiment, the second, fourth, sixth and eighth transmission lines TL2, TL4, TL6, and TL8 may be spaced apart from the first, third, fifth and seventh transmission lines TL1, TL3, TL5, and TL7 in the third direction D3, for example.

In an embodiment, the pad region PA may include an overlapping region OA and a non-overlapping region NOA. The overlapping region OA may be a region which overlaps the first to eighth upper electrodes PD1b, PD2b, PD3b, PD4b, PD5b, PD6b, PD7b, and PD8b. The overlapping region OA may extend in the first direction D1. The non-overlapping region NOA may be a region which does not overlap the first to eighth upper electrodes PD1b, PD2b, PD3b, PD4b, PD5b, PD6b, PD7b, and PD8b and upper electrodes PDb of another adjacent column. The non-overlapping region NOA may be disposed in each of the second direction D2 and the third direction D3 from the overlapping region OA, and may extend in the first direction D1.

The first to eighth transmission lines TL1, TL2, TL3, TL4, TL5, TL6, TL7, and TL8 may be disposed in the overlapping region OA. That is, in the pad region PA, the first to eighth transmission lines TL1, TL2, TL3, TL4, TL5, TL6, TL7, and TL8 may be disposed between the first lower electrode PD1a and the second lower electrode PD2a.

In an embodiment, the first upper electrode PD1b may overlap each of the first to eighth transmission lines TL1, TL2, TL3, TL4, TL5, TL6, TL7, and TL8 in a plan view. The second upper electrode PD2b may overlap each of the second to eighth transmission lines TL2, TL3, TL4, TL5, TL6, TL7, and TL8, and may be spaced apart from the first transmission line TL1 in a plan view. The third upper electrode PD3b may overlap each of the third to eighth transmission lines TL3, TL4, TL5, TL6, TL7, and TL8, and may be spaced apart from each of the first and second transmission lines TL1 and TL2 in a plan view. The fourth upper electrode PD4b may overlap each of the fourth to eighth transmission lines TL4, TL5, TL6, TL7, and TL8, and may be spaced apart from each of the first to third transmission lines TL1, TL2, and TL3 in a plan view. The fifth upper electrode PD5b may overlap each of the fifth to eighth transmission lines TL5, TL6, TL7, and TL8, and may be spaced apart from each of the first to fourth transmission lines TL1, TL2, TL3 and TL4 in a plan view. The sixth upper electrode PD6b may overlap each of the sixth to eighth transmission lines TL6, TL7, and TL8, and may be spaced apart from each of the first to fifth transmission lines TL1, TL2, TL3, TL4, and TL5 in a plan view. The seventh upper electrode PD7b may overlap each of the seventh and eighth transmission lines TL7 and TL8, and may be spaced apart from the first to sixth transmission lines TL1, TL2, TL3, TL4, TL5, and TL6 in a plan view. The eighth upper electrode PD8b may overlap the eighth transmission line TL8, and may be spaced apart from each of the first to seventh transmission lines TL1, TL2, TL3, TL4, TL5, TL6, and TL7 in a plan view. However, this is merely one of embodiments, and the invention is not limited thereto.

Although it is illustrated in FIG. 3 that an interval between the seventh transmission line TL7 and the eighth transmission line TL8 in the second direction D2 is relatively large, in an embodiment, the first to eighth transmission lines TL1, TL2, TL3, TL4, TL5, TL6, TL7, and TL8 may be disposed at substantially uniform intervals in the second direction D2.

In another embodiment, other transmission lines may be further disposed between the seventh transmission line TL7 and the eighth transmission line TL8. In an embodiment, ninth and tenth pads may be further disposed in the first direction D1 of the eighth pad PD8, and ninth and tenth transmission lines respectively connected to the ninth and tenth pads may be disposed between the seventh transmission line TL7 and the eighth transmission line TL8. That is, a number of pads PD constituting one column may be increased, for example. Accordingly, the display device 10 may implement a high resolution.

Referring to FIGS. 1, 3, and 5, the anisotropic conductive film 300 and the driving circuit chip 200 may be disposed on the pads PD. The anisotropic conductive film 300 may include a resin layer 310 and a plurality of conductive balls 320 dispersed in the resin layer 310. The driving circuit chip 200 may include a base substrate 210 and a plurality of bumps 220 disposed under the base substrate 210 and spaced apart from each other. The upper electrodes PDb may be respectively connected to the bumps 220 through at least one conductive ball 320. In an embodiment, the first upper electrode PD1b may be connected to a first bump, and the second upper electrode PD2b may be connected to a second bump spaced apart from the first bump, for example. As each of the upper electrodes PDb extends in the second direction D2, each of the upper electrodes PDb may have a relatively large area. Accordingly, a connection failure between the pads PD of the display panel 100 and the bumps 220 of the driving circuit chip 200 may be prevented or reduced. Accordingly, a reliability of the display device 10 may be improved.

In addition, the lower electrodes PDa and the transmission lines TL may be disposed in a different layer from the upper electrodes PDb contacting the anisotropic conductive film 300. Accordingly, even when an area of each of the lower electrodes PDa is reduced, each of the pads PD may be sufficiently connected to a corresponding bump 220 through the upper electrode PDb having a relatively large area. Accordingly, the area of each of the lower electrodes PDa may be reduced (e.g., a width of each of the lower electrodes PDa in the second direction D2 may be reduced), and an area of a region in which the transmission lines TL may be disposed (e.g., a region excluding the lower electrodes PDa) of the pad region PA may be increased. Accordingly, a short failure between adjacent transmission lines TL may be prevented or reduced. In addition, as described above, the number of pads PD constituting one column may be increased. Accordingly, the display device 10 may implement a high resolution.

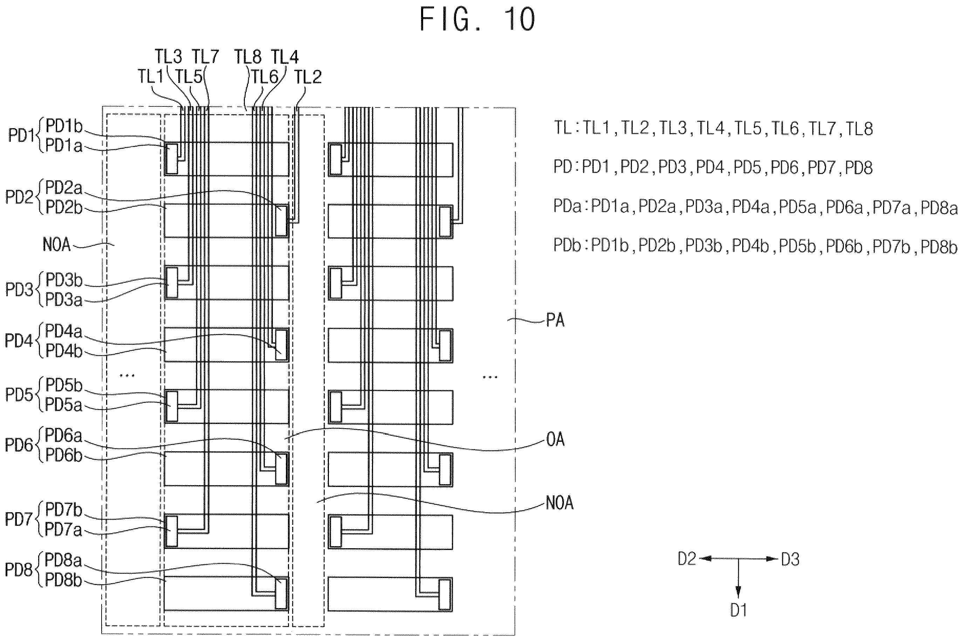

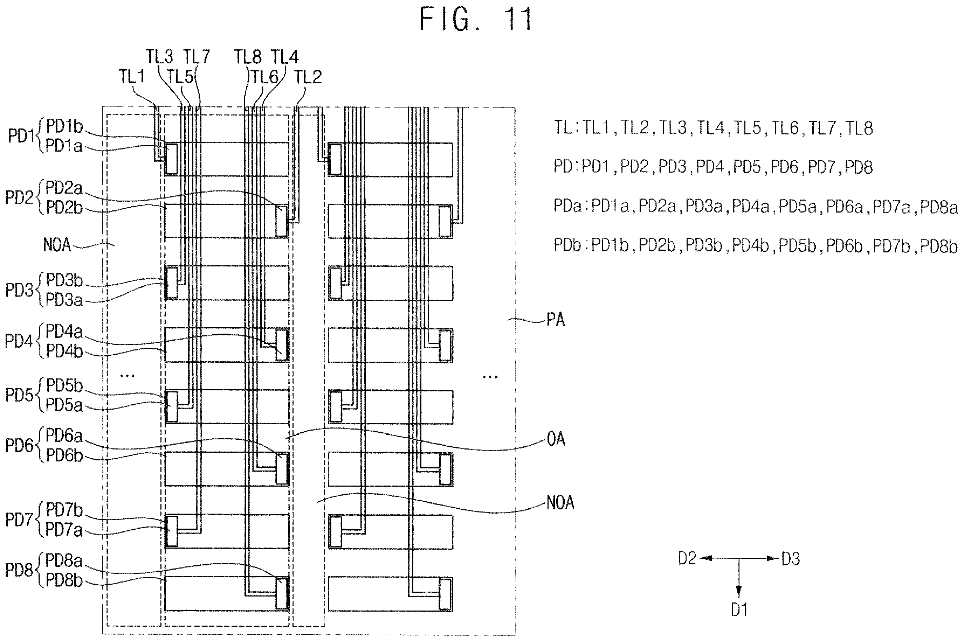

FIG. 10 is an enlarged plan view of another embodiment of a pad region of the display device of FIG. 1. FIG. 11 is an enlarged plan view of still another embodiment of a pad region of the display device of FIG. 1. Hereinafter, differences from the embodiment described with reference to FIGS. 3 to 9 will be mainly described.

Referring to FIGS. 1, 10, and 11, in an embodiment, some of the first to eighth transmission lines TL1, TL2, TL3, TL4, TL5, TL6, TL7, and TL8 may be disposed in the non-overlapping region NOA. That is, in the pad region PA, some of the first to eighth transmission lines TL1, TL2, TL3, TL4, TL5, TL6, TL7, and TL8 may be disposed outside (i.e., in the second direction D2 or the third direction D3) of the first upper electrode PD1b.

In an embodiment, as illustrated in FIG. 10, the second transmission line TL2 may be disposed in the non-overlapping region NOA, and the first and the third to eighth transmission lines TL1, TL3, TL4, TL5, TL6, TL7, and TL8 may be disposed in the overlapping region OA, for example. The second transmission line TL2 may be disposed in the third direction D3 from the first upper electrode PD1b. In this case, the first upper electrode PD1b may overlap each of the first and the third to eighth transmission lines TL1, TL3, TL4, TL5, TL6, TL7, and TL8, and may be spaced apart from the second transmission TL2 in a plan view.

In another embodiment, as illustrated in FIG. 11, the first and second transmission lines TL1 and TL2 may be disposed in the non-overlapping region NOA, and the third to eighth transmission lines TL3, TL4, TL5, TL6, TL7, and TL8 may be disposed in the overlapping region OA, for example. The first transmission line TL1 may be disposed in the second direction D2 from the first upper electrode PD1b. The second transmission line TL2 may be disposed in the third direction D3 from the first upper electrode PD1b. However, this is merely one of embodiments, the invention is not limited thereto, and another transmission line among the first to eighth transmission lines TL1, TL2, TL3, TL4, TL5, TL6, TL7, and TL8 may be disposed in the non-overlapping region NOA.

When some of the first to eighth transmission lines TL1, TL2, TL3, TL4, TL5, TL6, TL7, and TL8 are disposed in the non-overlapping region NOA and others are disposed in the overlapping region OA, a distance between adjacent transmission lines TL may be relatively large. Accordingly, the short failure between adjacent transmission lines TL may be prevented or reduced. In addition, the display device 10 may implement a high resolution.

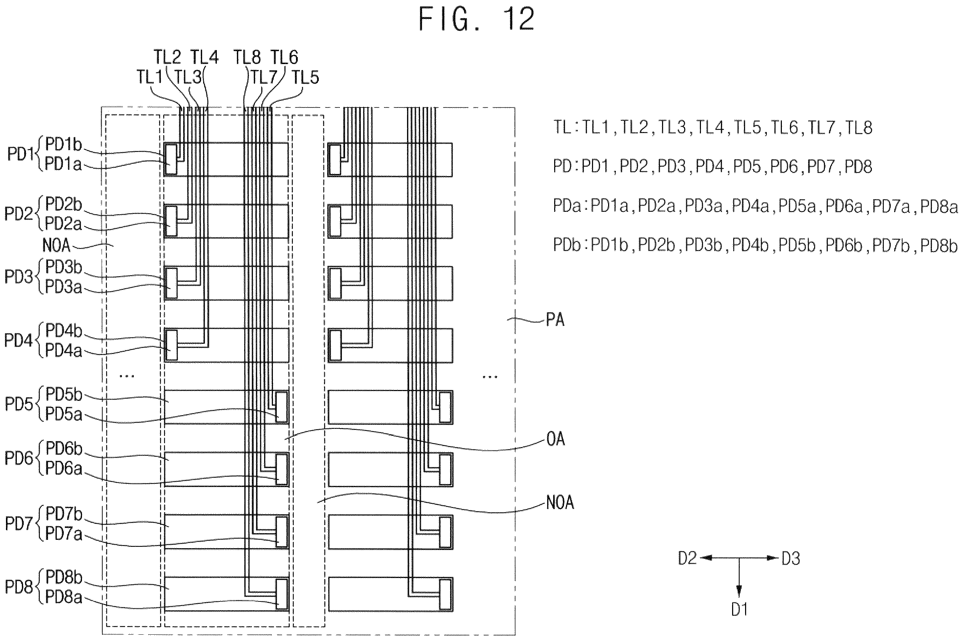

FIG. 12 is an enlarged plan view of still another embodiment of a pad region of the display device of FIG. 1. Hereinafter, differences from the embodiment described with reference to FIGS. 3 to 9 will be mainly described.

Referring to FIGS. 1 and 12, in an embodiment, the first lower electrode PD1a may overlap an end portion of the first upper electrode PD1b in the second direction D2. The second lower electrode PD2a may overlap an end portion of the second upper electrode PD2b in the second direction D2. The third lower electrode PD3a may overlap an end portion of the third upper electrode PD3b in the second direction D2. The fourth lower electrode PD4a may overlap an end portion of the fourth upper electrode PD4b in the second direction D2.

The fifth lower electrode PD5a may overlap an end portion of the fifth upper electrode PD5b in the third direction D3. The sixth lower electrode PD6a may overlap an end portion of the sixth upper electrode PD6b in the third direction D3. The seventh lower electrode PD7a may overlap an end portion of the seventh upper electrode PD7b in the third direction D3. The eighth lower electrode PD8a may overlap an end portion of the eighth upper electrode PD8b in the third direction D3.

Although it is illustrated in FIG. 12 that all of the first to eighth transmission lines TL1, TL2, TL3, TL4, TL5, TL6, TL7, and TL8 are disposed in the overlapping region OA, in an embodiment, some of the first to eighth transmission lines TL1, TL2, TL3, TL4, TL5, TL6, TL7, and TL8 may be disposed in the non-overlapping region NOA.

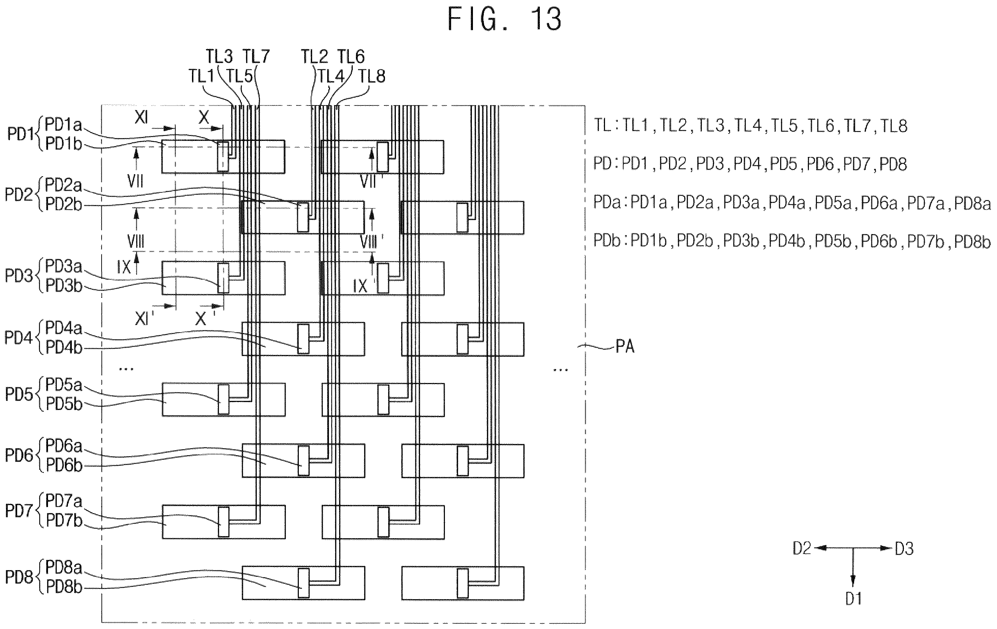

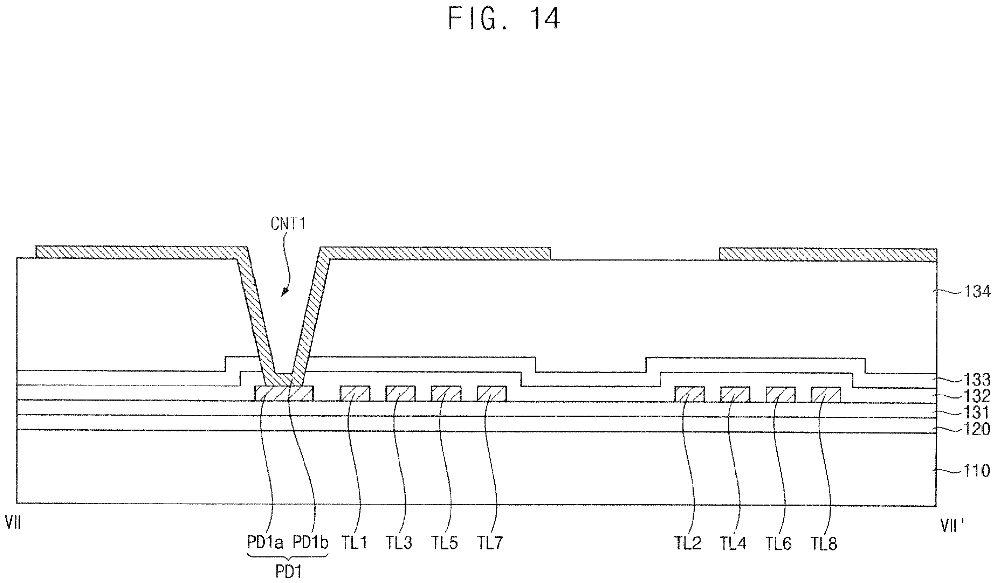

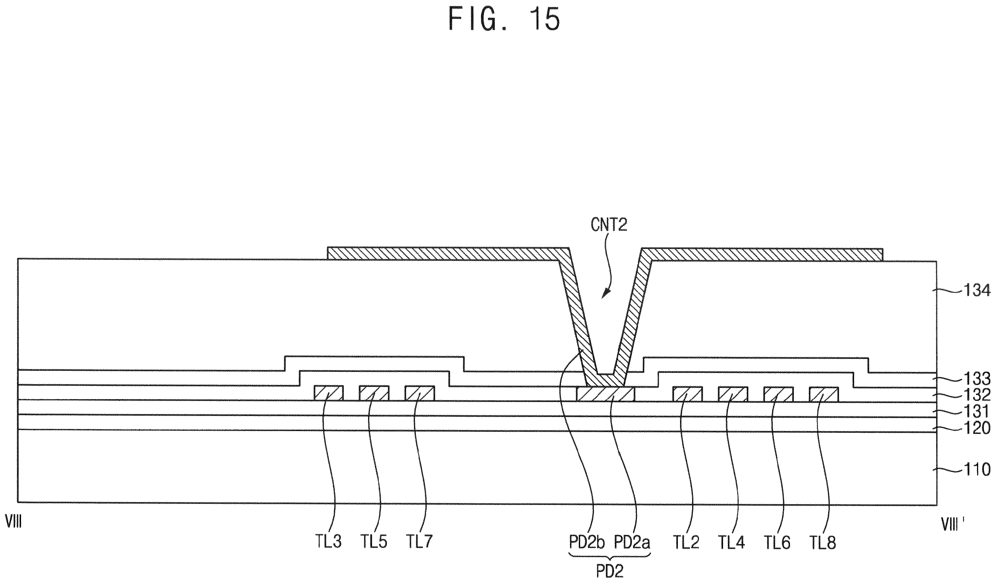

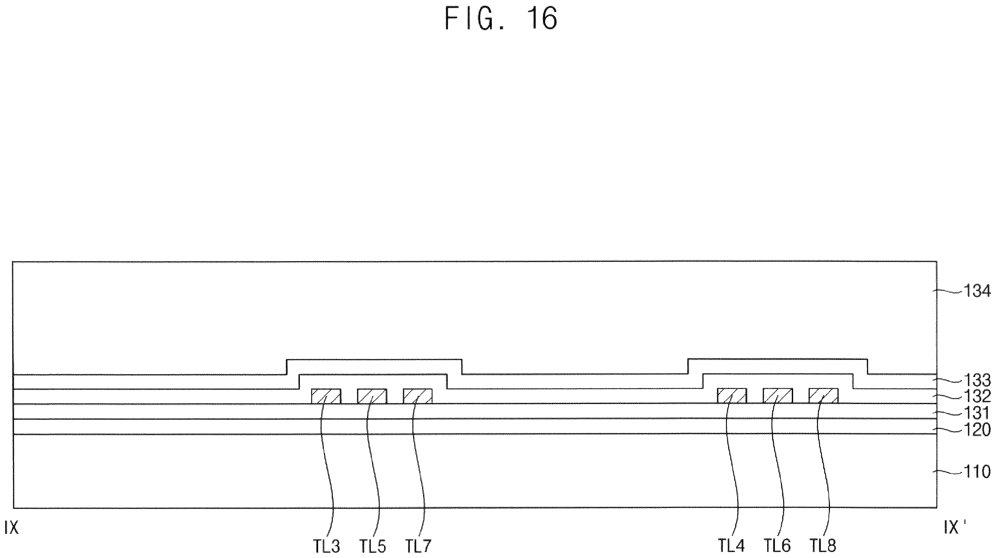

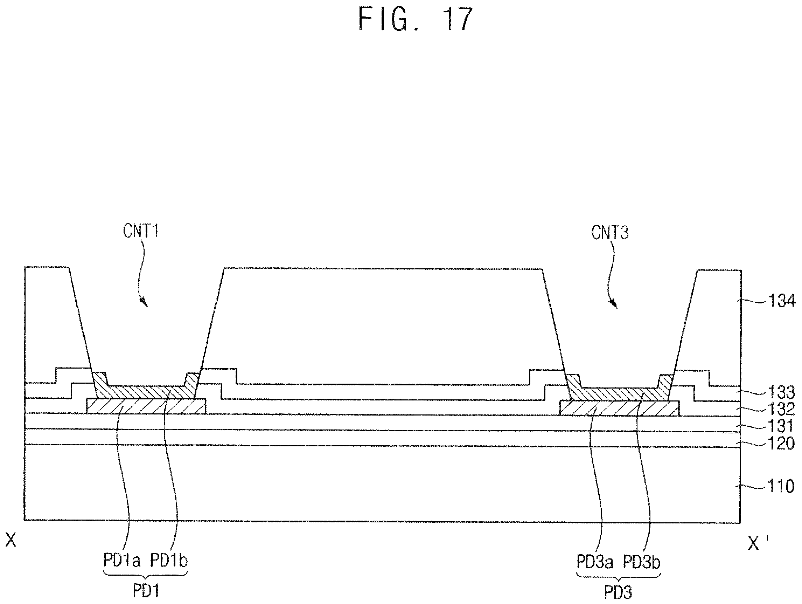

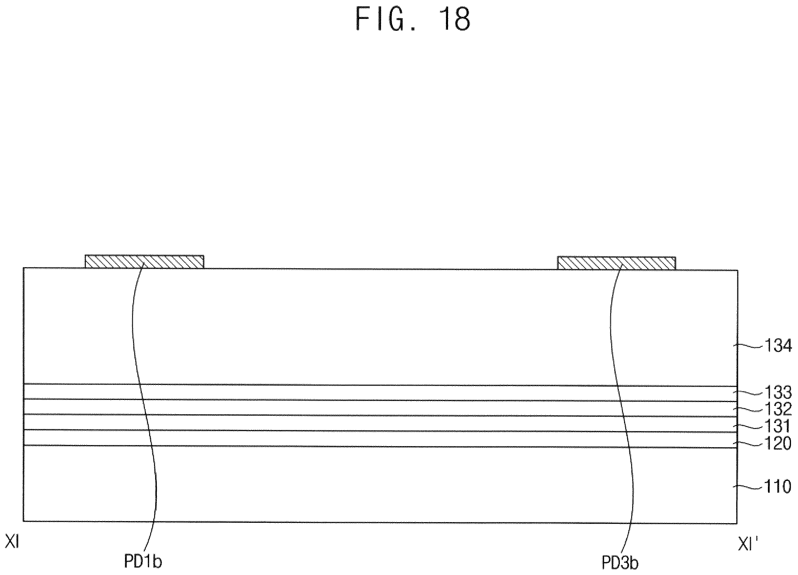

FIG. 13 is an enlarged plan view of still another embodiment of a pad region of the display device of FIG. 1. FIG. 14 is a cross-sectional view taken along line VII-VII' of FIG. 13. FIG. 15 is a cross-sectional view taken along line VIII-VIII' of FIG. 13. FIG. 16 is a cross-sectional view taken along line IX-IX' of FIG. 13. FIG. 17 is a cross-sectional view taken along line X-X' of FIG. 13. FIG. 18 is a cross-sectional view taken along line XI-XI' of FIG. 13. Hereinafter, differences from the embodiment described with reference to FIGS. 3 to 9 will be mainly described.

Referring to FIGS. 1, 13, 14, 15, 16, 17, and 18, in an embodiment, the plurality of pads PD may be disposed in a zigzag form in a plan view. The upper electrodes PDb may be disposed in a zigzag form in a plan view. Each of the lower electrodes PDa may overlap a central portion of the corresponding upper electrode PDb in the length direction thereof (i.e., the second direction D2). Accordingly, the upper electrodes PDb may be disposed in a zigzag form in a plan view.

In an embodiment, the first to eighth pads PD1, PD2, PD3, PD4, PD5, PD6, PD7, and PD8 constituting one column may be disposed in a zigzag form along the first direction D1, for example.

The first to eighth upper electrodes PD1b, PD2b, PD3b, PD4b, PD5b, PD6b, PD7b, and PD8b may be disposed in a zigzag form along the first direction D1. Each of the first to eighth lower electrodes PD1a, PD2a, PD3a, PD4a, PD5a, PD6a, PD7a, and PD8a may overlap the central portion of the corresponding one among the first to eighth upper electrodes PD1b, PD2b, PD3b, PD4b, PD5b, PD6b, PD7b, and PD8b in the length direction thereof. Accordingly, the first to eighth lower electrodes PD1a, PD2a, PD3a, PD4a, PD5a, PD6a, PD7a, and PD8a may be disposed in a zigzag form along the first direction D1. In addition, the contact holes defined in the insulating layer may be disposed in a zigzag form along the first direction D1.

In the pad region PA, the first, third, fifth, and seventh transmission lines TL1, TL3, TL5, and TL7 may be disposed in the third direction D3 from the first lower electrode PD1a. The first, third, fifth, and seventh transmission lines TL1, TL3, TL5, and TL7 may be disposed in the second direction D2 from the second lower electrode PD2a. The second, fourth, sixth, and eighth transmission lines TL2, TL4, TL6, and TL8 may be disposed in the third direction D3 from the second lower electrode PD2a.

In some embodiments, each of the pads PD disposed in the pad region PA may include the lower electrode PDa and the upper electrode PDb. Each of the upper electrodes PDb may extend in the second direction D2, and may be connected to the corresponding bump 220 through the anisotropic conductive film 300. As each of the upper electrodes PDb extends in the second direction D2, each of the upper electrodes PDb may have a relatively large area. Accordingly, the connection failure between the pads PD of the display panel 100 and the bumps 220 of the driving circuit chip 200 may be prevented or reduced. Accordingly, the reliability of the display device 10 may be improved.

In addition, the lower electrodes PDa and the transmission lines TL may be disposed in a different layer from the upper electrodes PDb contacting the anisotropic conductive film 300. Accordingly, even when an area of each of the lower electrodes PDa is reduced, each of the pads PD may be sufficiently connected to a corresponding bump 220 through the upper electrode PDb having a relatively large area. Accordingly, the area of each of the lower electrodes PDa may be reduced (e.g., a width of each of the lower electrodes PDa in the second direction D2 may be reduced), and an area of a region in which the transmission lines TL may be disposed (e.g., a region excluding the lower electrodes PDa) of the pad region PAmay be increased. Accordingly, the short failure between adjacent transmission lines TL may be prevented or reduced. In addition, as described above, the number of pads PD constituting one column may be increased. Accordingly, the display device 10 may implement a high resolution.

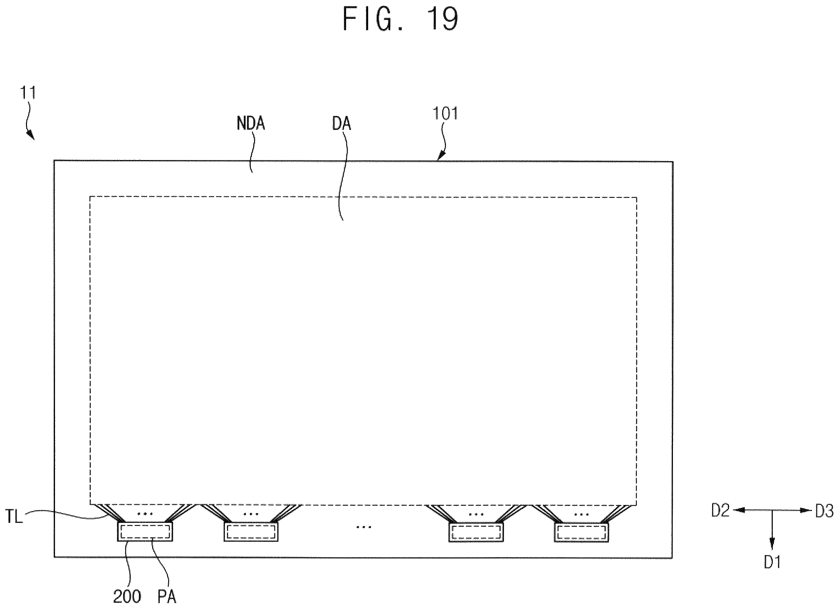

FIG. 19 is a plan view illustrating another embodiment of a display device.

Referring to FIG. 19, a display device 11 in another embodiment may include a display panel 101 and a plurality of driving circuit chips 200. The display panel 101 of FIG. 19 may have a relatively large area compared to the display panel 100 of FIG. 1. The display panel 101 may include a display region DA and a non-display region NDA. A plurality of pixels for generating an image may be disposed in the display region DA. The non-display region NDA may be disposed around the display region DA. The non-display region NDA may include a plurality of pad regions PA. The driving circuit chips 200 may be disposed (e.g., mounted) in the pad regions PA of the display panel 101, respectively. A plurality of pads may be disposed in each pad region PA. A plurality of transmission lines TL may be disposed between the display region DA and each pad region PA. The embodiments described with reference to FIGS. 3 to 18 may also be applied to the display panel 101 having a relatively large area illustrated in FIG. 19.

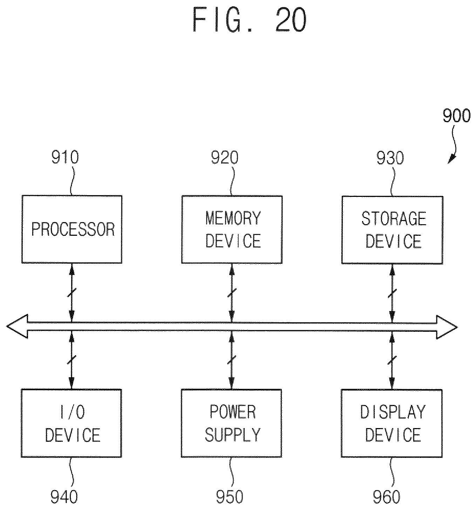

FIG. 20 is a block diagram illustrating an embodiment of an electronic device including a display device.

Referring to FIG. 20, in an embodiment, an electronic device 900 may include a processor 910, a memory device 920, a storage device 930, an input/output ("I/O") device 940, a power supply 950, and a display device 960. Here, the display device 960 may correspond to the display device 10 of FIG. 1 or the display device 11 of FIG. 19. The electronic device 900 may further include a plurality of ports for communicating with a video card, a sound card, a memory card, a universal serial bus ("USB") device, or the like. In an embodiment, the electronic device 900 may be implemented as a television. In another embodiment, the electronic device 900 may be implemented as a smart phone. However, the invention is not limited thereto, in another embodiment, the electronic device 900 may be implemented as a cellular phone, a video phone, a smart pad, a smart watch, a tablet personal computer ("PC"), a car navigation system, a computer monitor, a laptop, a head disposed (e.g., mounted) display ("HMD"), or the like.

The processor 910 may perform various computing functions. In an embodiment, the processor 910 may be a microprocessor, a central processing unit ("CPU"), an application processor ("AP"), or the like. The processor 910 may be coupled to other components via an address bus, a control bus, a data bus, or the like. In an embodiment, the processor 910 may be coupled to an extended bus such as a peripheral component interconnection ("PCI") bus.

The memory device 920 may store data for operations of the electronic device 900. In an embodiment, the memory device 920 may include at least one non-volatile memory device such as an erasable programmable read-only memory ("EPROM") device, an electrically erasable programmable read-only memory ("EEPROM") device, a flash memory device, a phase change random access memory ("PRAM") device, a resistance random access memory ("RRAM") device, a nano floating gate memory ("NFGM") device, a polymer random access memory ("PoRAM") device, a magnetic random access memory ("MRAM") device, a ferroelectric random access memory ("FRAM") device, or the like, and/or at least one volatile memory device such as a dynamic random access memory ("DRAM") device, a static random access memory ("SRAM") device, a mobile DRAM device, or the like.

In an embodiment, the storage device 930 may include a solid state drive ("SSD") device, a hard disk drive ("HDD") device, a compact disc read-only memory ("CD-ROM") device, or the like. In an embodiment, the I/O device 940 may include an input device such as a keyboard, a keypad, a mouse device, a touchpad, a touch-screen, or the like, and an output device such as a printer, a speaker, or the like.

The power supply 950 may provide power for operations of the electronic device 900. The display device 960 may be coupled to other components via the buses or other communication links. In an embodiment, the display device 960 may be included in the I/O device 940.

## Claims

1. A display panel (100) comprising:
a substrate (110) including a display region (DA) and a pad region (PA) spaced apart from the display region (DA) in a first direction (D1);
a plurality of pixels disposed in the display region (DA) on the substrate (110);
a plurality of pads (PD) disposed in the pad region (PA) on the substrate (110), each of the plurality of pads (PD) including a lower electrode (PDa) and a upper electrode (PDb) disposed on the lower electrode (PDa); and
a plurality of transmission lines (TL) respectively connected to the plurality of pads (PD),
**characterized in that**
a length of each of the lower electrodes (PDa) in the first direction (D1) is greater than a width of each of the lower electrodes (PDa) in a second direction (D2) crossing the first direction (D1), and wherein
a length of each of the upper electrode (PDb) in the second direction (D2) is greater than a width of each of the upper electrode (PDb) in the first direction (D1).

2. The display panel (100) of claim 1, wherein each of the lower electrodes (PDa) extends in the first direction (D1).

3. The display panel (100) of claim 1 or 2, wherein a width of each of the lower electrodes (PDa) in the second direction (D2) is less than a length of each of the upper electrodes (PDb) in the second direction (D2).

4. The display panel (100) of claim 3, wherein each of the lower electrodes (PDa) overlaps one of opposite end portions of a corresponding upper electrode (PDb) of the upper electrodes (PDb) in a length direction of the corresponding upper electrode (PDb).

5. The display panel (100) of claim 3, wherein each of the lower electrodes (PDa) overlaps a central portion of a corresponding upper electrode (PDb) of the upper electrodes (PDb) in a length direction of the corresponding upper electrode (PD1b).

6. The display panel (100) of at lest one of claims 1 to 5, wherein at least one of the upper electrodes (PDb) overlaps at least two transmission lines of the plurality of transmission lines (TL) in a plan view.

7. The display panel (100) of at least one of claims 1 to 6, wherein the plurality of transmission lines (TL) is disposed in a same layer as the lower electrodes (PDa).

8. The display panel (100) of at least one of claims 1 to 7, wherein the upper electrodes (PDb) are disposed in a matrix form along the first direction (D1) and the second direction (D2) in a plan view.

9. The display panel (100) of claim 8, wherein the lower electrodes (PDa) are disposed in a zigzag form in the plan view.

10. The display panel (100) of at least one of claims 1 to 8, wherein the plurality of pads (PD) includes:
a first pad (PD1) including:
a first lower electrode (PD1a) connected to a first transmission line (TL1) among the plurality of transmission lines (TL); and
a first upper electrode (PD1b) disposed on the first lower electrode (PD1a);
a second pad (PD2) including:
a second lower electrode (PD2a) connected to a second transmission line (TL2) among the plurality of transmission lines (TL); and
a second upper electrode (PD2b) disposed on the second lower electrode (PD2a) and adjacent to the first upper electrode (PD1b) in the first direction (D1).

11. The display panel (100) of claim 10, wherein the first lower electrode (PD1a) overlaps an end portion of the first upper electrode (PD1b) in the second direction (D2) in the plan view, and
wherein the second lower electrode (PD2a) overlaps an end portion of the second upper electrode (PD2b) in a second or third direction (D2, D3) opposite to the second direction (D2) in the plan view.

12. The display panel (100) of claim 10 or 11, wherein the first upper electrode (PD1b) overlaps each of the first transmission line (TL1) and the second transmission line (TL2) in the plan view.

13. The display panel (100) of claim 12, wherein the second upper electrode (PD2b) overlaps the second transmission line (TL2), and is spaced apart from the first transmission line (TL1) in the plan view.

14. The display panel (100) of claim 10 or 11, wherein the first upper electrode (PD1b) overlaps the first transmission line (TL1), and is spaced apart from the second transmission line (TL2) in the plan view.

15. The display panel (100) of at least one of claims 10 to14, wherein the second transmission line (TL2) is spaced apart from the first transmission line (TL1) in the third direction (D3) in the plan view.

16. The display panel (100) of claim 10 or 11, wherein each of the first transmission line (TL1) and the second transmission line (TL2) is disposed between the first lower electrode (PD1a) and the second lower electrode (PD2a) in the plan view.

17. The display panel (100) of at least one of claims 10 to 16, wherein the plurality of pads (PD) further includes:
a third pad (PD3) including:
a third lower electrode (PD3a) disposed connected to a third transmission line (TL3) among the plurality of transmission lines (TL); and
a third upper electrode (PD3b) disposed on the third lower electrode (PD3a) and adjacent to the second upper electrode (PD2b) in the first direction (D1), and
wherein the third lower electrode (PD3a) overlaps an end portion of the third upper electrode (PD3b) in the second or third direction (D2, D3) in the plan view.

18. The display panel (100) of claim 17, wherein the first upper electrode (PD1b) overlaps each of the first transmission line (TL1), the second transmission line (TL2), and the third transmission line (TL3) in the plan view,
wherein the second upper electrode (PD2b) overlaps each of the second transmission line (TL2) and the third transmission line (TL3), and is spaced apart from the first transmission line (TL1) in the plan view, and
wherein the third upper electrode (PD3b) overlaps the third transmission line (TL3), and is spaced apart from each of the first transmission line (TL1) and the second transmission line (TL2) in the plan view.

19. The display panel (100) of claim 10, wherein the first lower electrode (PD1a) overlaps an end portion of the first upper electrode (PD1b) in the second direction (D2) in the plan view, and
wherein the second lower electrode (PD2a) overlaps an end portion of the second upper electrode (PD2b) in the second direction (D2) in the plan view.

20. The display panel (100) of claim 19, wherein the first upper electrode (PD1b) overlaps each of the first transmission line (TL1) and the second transmission line (TL2) in the plan view, and
wherein the second upper electrode (PD2b) overlaps the second transmission line (TL2), and is spaced apart from the first transmission line (TL1) in the plan view.

21. The display panel (100) of at least one of claims 1 to 20 when not dependent on claim 8, wherein the upper electrodes are disposed in a zigzag form in a plan view.

22. The display panel (100) of claim 21, wherein each of the lower electrodes overlaps a central portion of a corresponding upper electrode of the upper electrodes in a length direction of the corresponding upper electrode.

23. The display panel (100) of at least one of claims 1 to 22, further comprising an organic insulating layer disposed between the lower electrodes and the upper electrodes, and
wherein each of the upper electrodes contacts a corresponding electrode of the lower electrodes through a contact hole (CNT) defined in the organic insulating layer.

24. The display panel (100) of at least one of claims 1 to 23, wherein each of the plurality of pixels includes:
a transistor (TR) including an active layer (AL), a gate electrode (GE) disposed on the active layer (AL), and a source electrode (SE) and a drain electrode (DE) disposed on the gate electrode (GE); and
a light-emitting element (LED) including an anode electrode (AE) disposed on the source electrode (SE) and the drain electrode (DE), an emission layer (EL) disposed on the anode electrode (AE), and a cathode electrode (CE) disposed on the emission layer (EL), and
wherein each of the lower electrodes is disposed in a same layer as the gate electrode (GE), and each of the upper electrodes is disposed in a same layer as the anode electrode (AE).

25. A display device (10) with a display panel (100) of at least one of claims 1 to 24, comprising:
a driving circuit chip (200) disposed in the pad region (PA) on the display panel (100) and including a plurality of bumps (220); and
an anisotropic conductive film (300) disposed between the display panel (100) and the driving circuit chip (200) and respectively electrically connecting the plurality of pads (PD) and the plurality of bumps (220).

## Patentansprüche

1. Anzeigetafel (100), umfassend:
ein Substrat (110), das einen Anzeigebereich (DA) und einen Padbereich (PA) beinhaltet, der von dem Anzeigebereich (DA) in einer ersten Richtung (D1) beabstandet ist;
eine Vielzahl von Pixeln, die in dem Anzeigebereich (DA) auf dem Substrat (110) angeordnet sind;
eine Vielzahl von Pads (PD), die in dem Padbereich (PA) auf dem Substrat (110) angeordnet sind, wobei jede der Vielzahl von Pads (PD) eine untere Elektrode (PDa) und eine obere Elektrode (PDb) beinhaltet, die an der unteren Elektrode (PDa) angeordnet ist; und
eine Vielzahl von Übertragungsleitungen (TL), die jeweils mit der Vielzahl von Pads (PD) verbunden sind,
**dadurch gekennzeichnet, dass**
eine Länge von jeder der unteren Elektroden (PDa) in der ersten Richtung (D1) größer ist als eine Breite von jeder der unteren Elektroden (PDa) in einer zweiten Richtung (D2), welche die erste Richtung (D1) kreuzt, und wobei
eine Länge von jeder der oberen Elektrode (PDb) in der zweiten Richtung (D2) größer ist als eine Breite von jeder der oberen Elektrode (PDb) in der ersten Richtung (D1).

2. Anzeigetafel (100) nach Anspruch 1, wobei sich jede der unteren Elektroden (PDa) in der ersten Richtung (D1) erstreckt.

3. Anzeigetafel (100) nach Anspruch 1 oder 2, wobei eine Breite von jeder der unteren Elektroden (PDa) in der zweiten Richtung (D2) kleiner als eine Länge von jeder der oberen Elektroden (PDb) in der zweiten Richtung (D2) ist.

4. Anzeigetafel (100) nach Anspruch 3, wobei jede der unteren Elektroden (PDa) einen von gegenüberliegenden Endabschnitten einer entsprechenden oberen Elektrode (PDb) der oberen Elektroden (PDb) in einer Längenrichtung der entsprechenden oberen Elektrode (PDb) überlappt.

5. Anzeigetafel (100) nach Anspruch 3, wobei jede der unteren Elektroden (PDa) einen zentralen Abschnitt einer entsprechenden oberen Elektrode (PDb) der oberen Elektroden (PDb) in einer Längenrichtung der entsprechenden oberen Elektrode (PDb) überlappt.

6. Anzeigetafel (100) nach mindestens einem der Ansprüche 1 bis 5, wobei mindestens eine der oberen Elektroden (PDb) mindestens zwei Übertragungsleitungen der Vielzahl von Übertragungsleitungen (TL) in einer Draufsicht überlappt.

7. Anzeigetafel (100) nach mindestens einem der Ansprüche 1 bis 6, wobei die Vielzahl von Übertragungsleitungen (TL) in einer gleichen Schicht wie die unteren Elektroden (PDa) angeordnet ist.

8. Anzeigetafel (100) nach mindestens einem der Ansprüche 1 bis 7, wobei die oberen Elektroden (PDb) in einer Matrixform entlang der ersten Richtung (D1) und der zweiten Richtung (D2) in einer Draufsicht angeordnet sind.

9. Anzeigetafel (100) nach Anspruch 8, wobei die unteren Elektroden (PDa) in der Draufsicht in einer Zickzackform angeordnet sind.

10. Anzeigetafel (100) nach mindestens einem der Ansprüche 1 bis 8, wobei die Vielzahl von Pads (PD) Folgendes beinhaltet:
ein erstes Pad (PD1), beinhaltend:
eine erste untere Elektrode (PD1a), die mit einer ersten Übertragungsleitung (TL1) aus der Vielzahl von Übertragungsleitungen (TL) verbunden ist; und
eine erste obere Elektrode (PD1b), die an der ersten unteren Elektrode (PD1a) angeordnet ist;
ein zweites Pad (PD2), beinhaltend:
eine zweite untere Elektrode (PD2a), die mit einer zweiten Übertragungsleitung (TL2) aus der Vielzahl von Übertragungsleitungen (TL) verbunden ist; und
eine zweite obere Elektrode (PD2b), die an der zweiten unteren Elektrode (PD2a) angeordnet ist und in der ersten Richtung (D1) zu der ersten oberen Elektrode (PD1b) benachbart ist.

11. Anzeigetafel (100) nach Anspruch 10, wobei die erste untere Elektrode (PD1a) einen Endabschnitt der ersten oberen Elektrode (PD1b) in der zweiten Richtung (D2) in der Draufsicht überlappt und
wobei die zweite untere Elektrode (PD2a) einen Endabschnitt der zweiten oberen Elektrode (PD2b) in einer zweiten oder dritten Richtung (D2, D3) überlappt, die der zweiten Richtung (D2) in der Draufsicht entgegengesetzt ist.

12. Anzeigetafel (100) nach Anspruch 10 oder 11, wobei die erste obere Elektrode (PD1b)jede der ersten Übertragungsleitung (TL1) und der zweiten Übertragungsleitung (TL2) in der Draufsicht überlappt.

13. Anzeigetafel (100) nach Anspruch 12, wobei die zweite obere Elektrode (PD2b) die zweite Übertragungsleitung (TL2) überlappt und in der Draufsicht von der ersten Übertragungsleitung (TL1) beabstandet ist.

14. Anzeigetafel (100) nach Anspruch 10 oder 11, wobei die erste obere Elektrode (PD1b) die erste Übertragungsleitung (TL1) überlappt und in der Draufsicht von der zweiten Übertragungsleitung (TL2) beabstandet ist.

15. Anzeigetafel (100) nach mindestens einem der Ansprüche 10 bis 14, wobei die zweite Übertragungsleitung (TL2) in der Draufsicht von der ersten Übertragungsleitung (TL1) in der dritten Richtung (D3) beabstandet ist.

16. Anzeigetafel (100) nach Anspruch 10 oder 11, wobei jede der ersten Übertragungsleitung (TL1) und der zweiten Übertragungsleitung (TL2) zwischen der ersten unteren Elektrode (PD1a) und der zweiten unteren Elektrode (PD2a) in der Draufsicht angeordnet ist.

17. Anzeigetafel (100) nach mindestens einem der Ansprüche 10 bis 16, wobei die Vielzahl von Pads (PD) ferner Folgendes beinhaltet:
ein drittes Pad (PD3), beinhaltend:
eine dritte untere Elektrode (PD3a), die mit einer dritten Übertragungsleitung (TL3) aus der Vielzahl von Übertragungsleitungen (TL) verbunden angeordnet ist; und
eine dritte obere Elektrode (PD3b), die an der dritten unteren Elektrode (PD3a) angeordnet ist und in der ersten Richtung (D1) benachbart zu der zweiten oberen Elektrode (PD2b) ist, und
wobei die dritte untere Elektrode (PD3a) einen Endabschnitt der dritten oberen Elektrode (PD3b) in der zweiten oder dritten Richtung (D2, D3) in der Draufsicht überlappt.

18. Anzeigetafel (100) nach Anspruch 17, wobei die erste obere Elektrode (PD1b) jede der ersten Übertragungsleitung (TL1), der zweiten Übertragungsleitung (TL2) und der dritten Übertragungsleitung (TL3) in der Draufsicht überlappt,
wobei die zweite obere Elektrode (PD2b) jede der zweiten Übertragungsleitung (TL2) und der dritten Übertragungsleitung (TL3) überlappt und in der Draufsicht von der ersten Übertragungsleitung (TL1) beabstandet ist und
wobei die dritte obere Elektrode (PD3b) die dritte Übertragungsleitung (TL3) überlappt und in der Draufsicht von jeder der ersten Übertragungsleitung (TL1) und der zweiten Übertragungsleitung (TL2) beabstandet ist.

19. Anzeigetafel (100) nach Anspruch 10, wobei die erste untere Elektrode (PD1a) einen Endabschnitt der ersten oberen Elektrode (PD1b) in der zweiten Richtung (D2) in der Draufsicht überlappt und
wobei die zweite untere Elektrode (PD2a) in der Draufsicht einen Endabschnitt der zweiten oberen Elektrode (PD2b) in der zweiten Richtung (D2) überlappt.

20. Anzeigetafel (100) nach Anspruch 19, wobei die erste obere Elektrode (PD1b) jede der ersten Übertragungsleitung (TL1) und der zweiten Übertragungsleitung (TL2) in der Draufsicht überlappt und
wobei die zweite obere Elektrode (PD2b) die zweite Übertragungsleitung (TL2) überlappt und in der Draufsicht von der ersten Übertragungsleitung (TL1) beabstandet ist.

21. Anzeigetafel (100) nach mindestens einem der Ansprüche 1 bis 20, wenn nicht von Anspruch 8 abhängig, wobei die oberen Elektroden in einer Draufsicht in einer Zickzackform angeordnet sind.

22. Anzeigetafel (100) nach Anspruch 21, wobei jede der unteren Elektroden einen zentralen Abschnitt einer entsprechenden oberen Elektrode der oberen Elektroden in einer Längenrichtung der entsprechenden oberen Elektrode überlappt.

23. Anzeigetafel (100) nach mindestens einem der Ansprüche 1 bis 22, ferner umfassend eine organische Isolierschicht, die zwischen den unteren Elektroden und den oberen Elektroden angeordnet ist, und
wobei jede der oberen Elektroden eine entsprechende Elektrode der unteren Elektroden durch ein Kontaktloch (CNT) berührt, das in der organischen Isolierschicht definiert ist.

24. Anzeigetafel (100) nach mindestens einem der Ansprüche 1 bis 23, wobei jedes der Vielzahl von Pixeln Folgendes beinhaltet:
einen Transistor (TR), der eine aktive Schicht (AL), eine Gate-Elektrode (GE), die auf der aktiven Schicht (AL) angeordnet ist, und eine Source-Elektrode (SE) und eine Drain-Elektrode (DE), die auf der Gate-Elektrode (GE) angeordnet sind, beinhaltet; und
ein lichtemittierendes Element (LED), das eine Anodenelektrode (AE), die an der Source-Elektrode (SE) und der Drain-Elektrode (DE) angeordnet ist, eine Emissionsschicht (EL), die an der Anodenelektrode (AE) angeordnet ist, und eine Kathodenelektrode (CE), die an der Emissionsschicht (EL) angeordnet ist, beinhaltet und
wobei jede der unteren Elektroden in einer gleichen Schicht wie die Gate-Elektrode (GE) angeordnet ist und jede der oberen Elektroden in einer gleichen Schicht wie die Anodenelektrode (AE) angeordnet ist.

25. Anzeigevorrichtung (10) mit einer Anzeigetafel (100) nach mindestens einem der Ansprüche 1 bis 24, umfassend:
einen Treiberschaltungschip (200), der in dem Padbereich (PA) auf der Anzeigetafel (100) angeordnet ist und eine Vielzahl von Höckern (220) beinhaltet; und
eine anisotrope leitfähige Folie (300), die zwischen der Anzeigetafel (100) und dem Treiberschaltungschip (200) angeordnet ist und jeweils die Vielzahl von Pads (PD) und die Vielzahl von Höckern (220) elektrisch verbindet.

## Revendications

1. Panneau d'affichage (100) comprenant :
un substrat (110) incluant une région d'affichage (DA) et une région de plot (PA) espacée de la région d'affichage (DA) dans une première direction (D1) ;
une pluralité de pixels disposés dans la région d'affichage (DA) sur le substrat (110) ;
une pluralité de plots (PD) disposés dans la région de plot (PA) sur le substrat (110), chacun de la pluralité de plots (PD) incluant une électrode inférieure (PDa) et une électrode supérieure (PDb) disposée sur l'électrode inférieure (PDa) ; et
une pluralité de lignes de transmission (TL) connectées respectivement à la pluralité de plots (PD), **caractérisé en ce que**
une longueur de chacune des électrodes inférieures (PDa) dans la première direction (D1) est supérieure à une largeur de chacune des électrodes inférieures (PDa) dans une deuxième direction (D2) croisant la première direction (D1), et dans lequel
une longueur de chaque électrode supérieure (PDb) dans la deuxième direction (D2) est supérieure à une largeur de chaque électrode supérieure (PDb) dans la première direction (D1).

2. Panneau d'affichage (100) selon la revendication 1, dans lequel chacune des électrodes inférieures (PDa) s'étend dans la première direction (D1).

3. Panneau d'affichage (100) selon la revendication 1 ou 2, dans lequel une largeur de chacune des électrodes inférieures (PDa) dans la deuxième direction (D2) est inférieure à une longueur de chacune des électrodes supérieures (PDb) dans la deuxième direction (D2).

4. Panneau d'affichage (100) selon la revendication 3, dans lequel chacune des électrodes inférieures (PDa) chevauche une des portions d'extrémité opposées d'une électrode supérieure (PDb) correspondante des électrodes supérieures (PDb) dans une direction de longueur de l'électrode supérieure (PDb) correspondante.

5. Panneau d'affichage (100) selon la revendication 3, dans lequel chacune des électrodes inférieures (PDa) chevauche une portion centrale d'une électrode supérieure (PDb) correspondante des électrodes supérieures (PDb) dans une direction de longueur de l'électrode supérieure (PDb) correspondante.

6. Panneau d'affichage (100) selon au moins l'une des revendications 1 à 5, dans lequel au moins l'une des électrodes supérieures (PDb) chevauche au moins deux lignes de transmission de la pluralité de lignes de transmission (TL) dans une vue en plan.

7. Panneau d'affichage (100) selon au moins l'une des revendications 1 à 6, dans lequel la pluralité de lignes de transmission (TL) est disposée dans une même couche que les électrodes inférieures (PDa).

8. Panneau d'affichage (100) selon au moins l'une des revendications 1 à 7, dans lequel les électrodes supérieures (PDb) sont disposées sous forme de matrice suivant la première direction (D1) et la deuxième direction (D2) dans une vue en plan.

9. Panneau d'affichage (100) selon la revendication 8, dans lequel les électrodes inférieures (PDa) sont disposées sous forme de zigzag dans la vue en plan.

10. Panneau d'affichage (100) selon au moins l'une des revendications 1 à 8, dans lequel la pluralité de plots (PD) inclut :
un premier plot (PD1) incluant :
une première électrode inférieure (PD1a) connectée à une première ligne de transmission (TL1) parmi la pluralité de lignes de transmission (TL) ; et
une première électrode supérieure (PD1b) disposée sur la première électrode inférieure (PD1a) ;
un deuxième plot (PD2) incluant :
une deuxième électrode inférieure (PD2a) connectée à une deuxième ligne de transmission (TL2) parmi la pluralité de lignes de transmission (TL) ; et
une deuxième électrode supérieure (PD2b) disposée sur la deuxième électrode inférieure (PD2a) et adjacente à la première électrode supérieure (PD1b) dans la première direction (D1).

11. Panneau d'affichage (100) selon la revendication 10, dans lequel la première électrode inférieure (PD1a) chevauche une portion d'extrémité de la première électrode supérieure (PD1b) dans la deuxième direction (D2) dans la vue en plan, et
dans lequel la deuxième électrode inférieure (PD2a) chevauche une portion d'extrémité de la deuxième électrode supérieure (PD2b) dans une deuxième ou troisième direction (D2, D3) opposée à la deuxième direction (D2) dans la vue en plan.

12. Panneau d'affichage (100) selon la revendication 10 ou 11, dans lequel la première électrode supérieure (PD1b) chevauche chacune de la première ligne de transmission (TL1) et de la deuxième ligne de transmission (TL2) dans la vue en plan.

13. Panneau d'affichage (100) selon la revendication 12, dans lequel la deuxième électrode supérieure (PD2b) chevauche la deuxième ligne de transmission (TL2), et est espacée de la première ligne de transmission (TL1) dans la vue en plan.

14. Panneau d'affichage (100) selon la revendication 10 ou 11, dans lequel la première électrode supérieure (PD1b) chevauche la première ligne de transmission (TL1), et est espacée de la deuxième ligne de transmission (TL2) dans la vue en plan.

15. Panneau d'affichage (100) selon au moins l'une des revendications 10 à 14, dans lequel la deuxième ligne de transmission (TL2) est espacée de la première ligne de transmission (TL1) dans la troisième direction (D3) dans la vue en plan.

16. Panneau d'affichage (100) selon la revendication 10 ou 11, dans lequel chacune de la première ligne de transmission (TL1) et de la deuxième ligne de transmission (TL2) est disposée entre la première électrode inférieure (PD1a) et la deuxième électrode inférieure (PD2a) dans la vue en plan.

17. Panneau d'affichage (100) selon au moins l'une des revendications 10 à 16, dans lequel la pluralité de plots (PD) inclut en outre :
un troisième plot (PD3) incluant :
une troisième électrode inférieure (PD3a) disposée connectée à une troisième ligne de transmission (TL3) parmi la pluralité de lignes de transmission (TL) ; et
une troisième électrode supérieure (PD3b) disposée sur la troisième électrode inférieure (PD3a) et adjacente à la deuxième électrode supérieure (PD2b) dans la première direction (D1), et
dans lequel la troisième électrode inférieure (PD3a) chevauche une portion d'extrémité de la troisième électrode supérieure (PD3b) dans la deuxième ou troisième direction (D2, D3) dans la vue en plan.

18. Panneau d'affichage (100) selon la revendication 17, dans lequel la première électrode supérieure (PD1b) chevauche chacune de la première ligne de transmission (TL1), de la deuxième ligne de transmission (TL2) et de la troisième ligne de transmission (TL3) dans la vue en plan,
dans lequel la deuxième électrode supérieure (PD2b) chevauche chacune de la deuxième ligne de transmission (TL2) et de la troisième ligne de transmission (TL3), et est espacée de la première ligne de transmission (TL1) dans la vue en plan, et
dans lequel la troisième électrode supérieure (PD3b) chevauche la troisième ligne de transmission (TL3), et est espacée de chacune de la première ligne de transmission (TL1) et de la deuxième ligne de transmission (TL2) dans la vue en plan.

19. Panneau d'affichage (100) selon la revendication 10, dans lequel la première électrode inférieure (PD1a) chevauche une portion d'extrémité de la première électrode supérieure (PD1b) dans la deuxième direction (D2) dans la vue en plan, et
dans lequel la deuxième électrode inférieure (PD2a) chevauche une portion d'extrémité de la deuxième électrode supérieure (PD2b) dans la deuxième direction (D2) dans la vue en plan.

20. Panneau d'affichage (100) selon la revendication 19, dans lequel la première électrode supérieure (PD1b) chevauche chacune de la première ligne de transmission (TL1) et de la deuxième ligne de transmission (TL2) dans la vue en plan, et
dans lequel la deuxième électrode supérieure (PD2b) chevauche la deuxième ligne de transmission (TL2), et est espacée de la première ligne de transmission (TL1) dans la vue en plan.

21. Panneau d'affichage (100) selon au moins l'une des revendications 1 à 20 lorsqu'elle ne dépend pas de la revendication 8, dans lequel les électrodes supérieures sont disposées sous forme de zigzag dans une vue en plan.

22. Panneau d'affichage (100) selon la revendication 21, dans lequel chacune des électrodes inférieures chevauche une portion centrale d'une électrode supérieure correspondante parmi les électrodes supérieures dans une direction de longueur de l'électrode supérieure correspondante.

23. Panneau d'affichage (100) selon au moins l'une des revendications 1 à 22, comprenant en outre une couche isolante organique disposée entre les électrodes inférieures et les électrodes supérieures, et
dans lequel chacune des électrodes supérieures est en contact avec une électrode correspondante des électrodes inférieures à travers un trou de contact (CNT) défini dans la couche isolante organique.

24. Panneau d'affichage (100) selon au moins l'une des revendications 1 à 23, dans lequel chacun de la pluralité de pixels inclut :
un transistor (TR) incluant une couche active (AL), une électrode de grille (GE) disposée sur la couche active (AL), et une électrode de source (SE) et une électrode de drain (DE) disposées sur l'électrode de grille (GE) ; et
un élément électroluminescent (DEL) incluant une électrode d'anode (AE) disposée sur l'électrode de source (SE) et l'électrode de drain (DE), une couche d'émission (EL) disposée sur l'électrode d'anode (AE), et une électrode de cathode (CE) disposée sur la couche d'émission (EL), et
dans lequel chacune des électrodes inférieures est disposée dans une même couche que l'électrode de grille (GE), et chacune des électrodes supérieures est disposée dans une même couche que l'électrode d'anode (AE).

25. Dispositif d'affichage (10) avec un panneau d'affichage (100) d'au moins l'une des revendications 1 à 24, comprenant :
une puce de circuit de pilotage (200) disposée dans la région de plot (PA) sur le panneau d'affichage (100) et incluant une pluralité de bosses (220) ; et
un film conducteur anisotrope (300) disposé entre le panneau d'affichage (100) et la puce de circuit de pilotage (200) et connectant électriquement respectivement la pluralité de plots (PD) et la pluralité de bosses (220).
